# EUROPÄISCHE PATENTSCHRIFT

(11) **EP 2 671 256 B1**
(45) Veröffentlichungstag und Bekanntmachung des Hinweises auf die Patenterteilung: **13.03.2019**
(21) Anmeldenummer: 11720111.1
(22) Anmeldetag: 18.05.2011
(51) Int. Cl.: H01L 31/02

(54) **SCHUTZEINRICHTUNG FÜR EINE PHOTOVOLTAIKANLAGE**
PROTECTIVE DEVICE FOR A PHOTOVOLTAIC SYSTEM
DISPOSITIF DE PROTECTION POUR INSTALLATION PHOTOVOLTAÏQUE

(30) Priorität: 02.02.2011 DE 102011010172; 15.02.2011 DE 102011000737
(43) Veröffentlichungstag der Anmeldung: 11.12.2013
(73) Patentinhaber: SMA Solar Technology AG, 34266 Niestetal (DE)
(72) Erfinder: HOPF, Markus, 34314 Espenau (DE); VICTOR, Matthias, 34266 Niestetal (DE); GREIZER, Frank, 34260 Kaufungen (DE); BETTENWORT, Gerd, 34119 Kassel (DE); FRIEBE, Jens, 34246 Vellmar (DE)
(86) Internationale Anmeldenummer: PCT/EP2011/058049
(87) Internationale Veröffentlichungsnummer: WO 2012/103963

(56) Entgegenhaltungen:
- EP-A2- 2 077 588
- WO-A2-2009/006879
- WO-A2-2010/078303
- DE-A1- 4 041 672
- DE-A1-102008 008 505

## Beschreibung

Die Erfindung betrifft eine Schutzeinrichtung für eine Photovoltaikanlage, die mindestens einen Eingang zur Verbindung mit einem Photovoltaikgenerator und mindestens einen Ausgang zur Abgabe einer von dem Photovoltaikgenerator gelieferten elektrischen Leistung aufweist. Die Erfindung betrifft weiterhin ein Photovoltaikmodul mit einer Schutzeinrichtung und ein Betriebsverfahren für eine Schutzeinrichtung einer Photovoltaikanlage.

Photovoltaikanlagen, im Folgenden abkürzend PV-Anlagen genannt, dienen der Umwandlung von Sonnenlicht in elektrische Energie. Üblicherweise wird dazu eine Vielzahl von Photovoltaikmodulen, im Folgenden abkürzend PV-Module genannt, von denen jedes eine Zusammenschaltung von mehreren Photovoltaikzellen darstellt, elektrisch als ein Photovoltaikgenerator zusammengeschaltet. Der Photovoltaikgenerator (PV-Generator) ist mit einem häufig entfernt montierten Wechselrichter verbunden, der der Umwandlung des von dem PV-Generator gelieferten Gleichstroms in Wechselstrom dient, welcher zur Einspeisung in ein öffentliches oder privates (Inselbetrieb) Stromversorgungsnetz geeignet ist.

Die PV-Module werden dabei meist derart serienverschaltet, dass die zwischen dem PV-Generator und dem Wechselrichter verlaufenden Gleichstromleitungen mit Spannungen im Bereich von deutlich mehr als 100 V beaufschlagt sind. Eine Spannung dieser Größenordnung ist aus Effizienzgründen sinnvoll, unter anderem um ohmsche Verluste in den Leitungen erträglich klein zu halten, ohne dass ein allzu großer Leitungsquerschnitt gewählt werden muss. Bei Lichteinfall auf die PV-Module besteht aufgrund der hohen Spannung jedoch bei Schadensfällen, z. B. im Brandfall, oder bei Installations- und Wartungsarbeiten die Gefahr eines lebensgefährlichen elektrischen Schlags. Ohne weitere Schutzmaßnahmen lässt sich die Lebensgefahr bei einer direkten Berührung oder einer indirekten Berührung, z. B. über Löschwasser, nur bannen, wenn die Stromerzeugung durch die PV-Module unterbunden wird, beispielsweise durch eine Verdunkelung der PV-Module. Dieses ist bei großen PV-Anlagen oder im Brandfall allerdings nur schwer umsetzbar.
Ein weiteres Problem bei PV-Anlagen stellt aufgrund der hohen Gleichspannung in Verbindung mit hohen Gleichströmen, die von den PV-Modulen zum Wechselrichter fließen, die Gefahr einer Lichtbogenbildung dar. Lichtbögen können beispielsweise bei Wartungsarbeiten (Trennen einer stromdurchflossenen Leitung) bei einer Degradation von Kontakten an Schraub- oder Steckverbindern, an schlechten Lötstellen oder schlechten Schraubverbindungen oder bei einer beschädigten Leitungsisolation entstehen. Ein Löschen eines entstandenen Lichtbogens ist üblicherweise nur durch eine drastische Reduzierung des über den Lichtbogen fließenden Stromes möglich.
Um beim Betrieb einer PV-Anlage das Auftreten von gefährlichen Spannungen im Brandfall oder bei Wartungsarbeiten zu vermeiden, ist es bekannt, in räumlicher Nähe zu den PV-Modulen, beispielsweise in einer Anschlussdose des PV-Moduls, Schaltorgane, z. B. Schütze oder Halbleiterschalter, anzuordnen, die vom Wechselrichter oder einer sonstigen Steuerzentrale über Zentralleitungen geschaltet die Verbindungsleitungen zwischen den PV-Modulen und dem Wechselrichter spannungslos schalten. Dieses kann durch eine Unterbrechung der Verbindungsleitungen durch die Schaltorgane geschehen oder durch ein Kurzschließen der PV-Module, wie beispielsweise in der Zeitschrift Photon, Ausgabe Mai 2005, S. 75-77 offenbart. Die Verbindungsleitungen zwischen dem PV-Generator und dem Wechselrichter können auch, wie in der Druckschrift DE 10 2005 018 173 A1 sowie in der Druckschrift WO 2010/078303 A2 offenbart, durch ein einzelnes, am PV-Generator angeordnetes Schaltorgan spannungslos geschaltet werden.
Zur Übertragung der Steuersignale zu den Schaltorganen werden dabei zusätzlich verlegte Steuerleitungen eingesetzt, was jedoch, insbesondere bei großen PV-Anlagen, mit einem erhöhten Installationsaufwand einhergeht. Als Alternative ist aus der Druckschrift DE 10 2006 060 815 A1 bekannt, die Steuersignale als Hochfrequenzsignale mittels eines Übertragers auf die Gleichstromleitungen zur Leistungsübertragung aufzubringen und über diese zu übertragen. Die Schaltorgane sind zu diesem Zweck mit einer Steuereinheit versehen, die die hochfrequent übertragenen Steuersignale dekodiert und den Schaltvorgang steuert. Auch diese Lösung ist aufwendig, da zum Aufbringen der Steuersignale angesichts der hohen Ströme auf den Gleichstromleitungen ein materialintensiver Übertrager benötigt wird.

Es ist daher eine Aufgabe der vorliegenden Erfindung, eine Schutzeinrichtung für eine PV-Anlage zu schaffen, die bei einfachem Aufbau zuverlässig und sicher verhindert, dass die von einem PV-Generator zu einem Wechselrichter führenden Gleichspannungsleitungen im Gefahrenfall mit hohen Spannungen beaufschlagt sind. Es ist eine weitere Aufgabe, ein Betriebsverfahren für eine solche Schutzeinrichtung anzugeben und ein PV-Modul zu schaffen, mit dem eine sichere PV-Anlage aufgebaut werden kann.

Diese Aufgabe wird durch eine Schutzeinrichtung mit den Merkmalen des Patentanspruchs 1 gelöst, sowie durch ein PV-Modul mit den Merkmalen des Anspruchs 16 und ein Betriebsverfahren mit den Merkmalen des Anspruchs 19. Weiterbildungen und vorteilhafte Ausgestaltungen sind in den abhängigen Ansprüchen angegeben.

Gemäß einem ersten Aspekt der Erfindung weist die Schutzeinrichtung gemäß dem eingangs genannten Oberbegriff eine Detektionseinrichtung für ein über den mindestens einen Ausgang zugeführtes Signal auf und ist dazu eingerichtet, dass am Ausgang eine in ihrer Höhe begrenzte Kleinspannung bereitgestellt wird, falls ein zugeführtes Signal vorgegebenen Kriterien nicht genügt, und dass der Ausgang über ein Schaltorgan niederohmig mit dem mindestens einen Eingang verbunden ist, falls das zugeführte Signal den vorgegebenen Kriterien genügt.

Die Schutzeinrichtung, die bevorzugt räumlich möglichst nah am PV-Generator angeordnet ist und mit ihrem Eingang mit dem PV-Generator und mit ihrem Ausgang mit einem ggf. entfernt positionierten Wechselrichter verbunden ist, beaufschlagt den Ausgang zunächst nur mit der ungefährlichen Kleinspannung. Auf diese Weise wird von der Schutzeinrichtung die Information übermittelt, dass eine Einstrahlung am PV-Generator vorliegt. Erst wenn ein Wechselrichter (oder eine andere generatorferne Einrichtung) darauf reagiert und ein vorbestimmtes Signal absetzt, verbindet die Schutzeinrichtung den Ausgang über das Schaltorgan niederohmig mit ihrem Eingang und beaufschlagt so die Gleichstrom-Verbindungsleitung zum Wechselrichter mit der vollen Spannung des PV-Generators, oder anders ausgedrückt, schaltet den PV-Generator auf die Gleichstromleitungen auf, wodurch dann die gesamte Leistung des PV-Generators an den Wechselrichter übertragen werden kann. Bei Abschaltung des Wechselrichters, z.B. im Gefahrenfall, ist das vorgegebene Kriterium nicht mehr erfüllt, beispielsweise weil das vorbestimmte Signal entfällt. Eingang und Ausgang der Schutzeinrichtung werden durch das Schaltorgan voneinander getrennt und der Ausgang ist wiederum nur mit der ungefährlichen Kleinspannung beaufschlagt.

Gemäß einer vorteilhaften Ausgestaltung der Schutzeinrichtung weist die Detektionseinrichtung eine Strommesseinrichtung für einen an dem mindestens einen Ausgang abgegebenen Strom auf, wobei das zugeführte Signal mit einer Höhe des Stroms verknüpft ist. Alternativ weist die Detektionseinrichtung eine Spannungsmesseinrichtung für eine an dem mindestens einen Ausgang anliegende Spannung auf, wobei das zugeführte Signal mit einer Höhe der Spannung verknüpft ist.

Gemäß einer weiteren vorteilhaften Ausgestaltung der Schutzeinrichtung betreffen die vorgegebenen Kriterien eine zeitliche Modulation des Signals, insbesondere ein Pulsmuster. Auf diese Weise wird eine sichere Erkennung eines Einschaltsignals erreicht.

Gemäß einer weiteren vorteilhaften Ausgestaltung betreffen die vorgegebenen Kriterien die Höhe des an dem mindestens einen Ausgang abgegebenen Stroms, wobei die Schutzeinrichtung dazu eingerichtet ist, die Kleinspannung an dem mindestens einen Ausgang bereitzustellen, falls der abgegebene Strom kleiner als ein unterer Schwellenwert ist und den mindestens einen Ausgang über das Schaltorgan niederohmig mit dem mindestens einen Eingang zu verbinden, wenn der abgegebene Strom größer oder gleich einem oberen Schwellenwert ist, wobei der obere Schwellenwert größer oder gleich dem unteren Schwellenwert ist.

Dadurch wird erreicht, dass die Schutzeinrichtung den PV-Generator dann auf die Gleichstromleitungen aufschaltet, wenn ein Wechselrichter seinen mit dieser Kleinspannung beaufschlagten Gleichstromeingang belastet und ein über dem oder am oberen Schwellenwert liegender Stromfluss am Ausgang der Schutzeinrichtung detektiert wird. Bei Abschaltung des Wechselrichters, z.B. im Gefahrenfall, wird umgekehrt der Gleichstromeingang des Wechselrichters und damit der Ausgang der Schutzeinrichtung nicht mehr belastet und Eingang und Ausgang der Schutzeinrichtung werden durch das Schaltorgan wieder voneinander getrennt. Die Schwellenwerte für den Stromfluss sollten dabei derart gewählt werden, dass ein Verbinden des Ausgangs der Schutzeinrichtung mit dem Eingang durch Berührung der Gleichstrom-Verbindungsleitungen, durch einen stark verringerten Isolationswiderstand oder durch die Leitfähigkeit von (Lösch-) Wasser ausgeschlossen ist.

Gemäß einer vorteilhaften Ausgestaltung der Schutzeinrichtung weist diese einen weiteren Eingang auf, um eine Teilspannung des PV-Generators zur unmittelbaren Bereitstellung oder zur Erzeugung der Kleinspannung zuzuführen. Auf diese Weise kann die Kleinspannung besonders ökonomisch ohne oder nur mit minimalen Wandelverlusten bereitgestellt werden.

Gemäß einer weiteren vorteilhaften Ausgestaltung der Schutzeinrichtung ist die Kleinspannung über einen Vorwiderstand hochohmig auf den mindestens einen Ausgang geschaltet. Dadurch wird unter anderem erreicht, dass sich bei mehreren, an ihren Ausgängen parallel geschalteten Schutzeinrichtungen bei Belastung der Kleinspannung ein Stromfluss an jeder der Schutzeinrichtungen einstellt und so jede der Schutzeinrichtungen ihre Schaltfunktion ausführen kann.

Gemäß einer weiteren vorteilhaften Ausgestaltung der Schutzeinrichtung weist diese eine Einrichtung zur Lichtbogenerkennung auf, die mit dem Schaltorgan zu dessen Steuerung verbunden ist. Bevorzugt ist die Einrichtung zur Lichtbogenerkennung derart mit dem Schaltorgan verbunden, dass das Schaltorgan trennt, wenn ein Lichtbogen erkannt wird. Auf diese Weise kann die Schutzeinrichtung auch zum automatischen Löschen von Lichtbögen eingesetzt werden. Die Integration von Spannungsschutz und der Lichtbogenlöschung in der Schutzeinrichtung ermöglicht einen ökonomischen Einsatz von Bauelementen, z.B. solchen Elementen wie dem Schaltorgan, das in beiden Fällen zum Einsatz kommt.

Gemäß einem zweiten Aspekt der Erfindung wird die Aufgabe durch ein PV-Modul gelöst, das eine derartige integrierte Schutzeinrichtung aufweist. Ein solches PV-Modul kann auf gleiche Art und Weise wie bekannte PV-Module innerhalb von PV-Anlagen eingesetzt werden und bietet ohne weitere Vorkehrungen die im Zusammenhang mit der Schutzeinrichtung zuvor beschriebenen Vorteile.

In einer vorteilhaften Ausgestaltung des PV-Moduls ist die Schutzeinrichtung in einer Anschlussdose des PV-Moduls angeordnet, was eine besonders kompakte Bauform ermöglicht.

Gemäß einem dritten Aspekt der Erfindung wird die Aufgabe durch ein Betriebsverfahren für eine Schutzeinrichtung einer PV-Anlage gelöst, wobei die Schutzeinrichtung mindestens einen Eingang zur Verbindung mit einem PV-Generator und mindestens einen Ausgang zur Abgabe einer von dem PV-Generator bereitgestellten elektrischen Leistung aufweist. Das Betriebsverfahren hat folgende Schritte: Der mindestens eine Ausgang wird mit einer Kleinspannung beaufschlagt und wird auf ein Vorliegen eines Signals überwacht, wobei ein vorliegendes Signal gegebenenfalls detektiert wird. Der mindestens eine Ausgang wird mit einer Betriebsspannung zur Abgabe der gesamten von dem PV-Generator bereitgestellten elektrischen Leistung beaufschlagt, wenn ein detektiertes Signal vorgegebenen Kriterien genügt. Wenn kein Signal vorliegt oder wenn das detektierte Signal vorgegebenen Kriterien nicht genügt, wird der Ausgang erneut mit der Kleinspannung beaufschlagt. Die Vorteile entsprechen denen des ersten und zweiten Aspekts.

Im Folgenden wird die Erfindung anhand von Ausführungsbeispielen mit Hilfe von sieben Figuren näher erläutert.

Die Figuren zeigen:
- Figur 1: eine schematische Darstellung einer PV-Anlage mit einer Schutzeinrichtung in einem ersten Ausführungsbeispiel;
- Figur 2: ein Flussdiagramm eines Betriebsverfahrens einer Schutzeinrichtung;
- Figur 3: ein Schaltbild eines zweiten Ausführungsbeispiels einer Schutzeinrichtung;
- Figur 4: ein Schaltbild eines dritten Ausführungsbeispiels einer Schutzeinrichtung;
- Figur 5: eine schematische Darstellung einer PV-Anlage mit mehreren Schutzeinrichtungen;
- Figur 6: ein Schaltbild eines vierten Ausführungsbeispiels einer Schutzeinrichtung und
- Figur 7: ein Schaltbild eines fünften Ausführungsbeispiels einer Schutzeinrichtung.

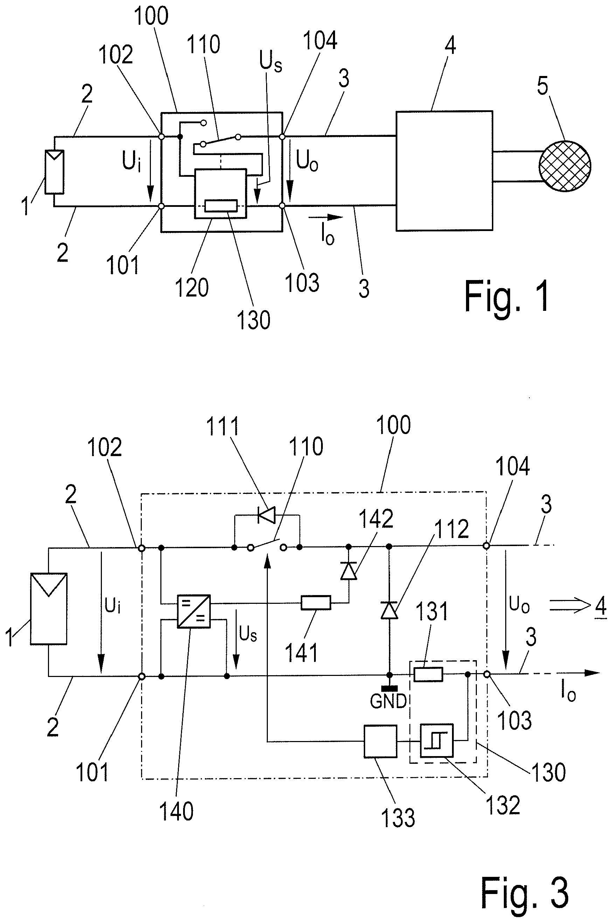

Figur 1 zeigt schematisch den Grundaufbau einer PV-Anlage mit einer Schutzeinrichtung in einem ersten Ausführungsbeispiel.

Die PV-Anlage weist einen PV-Generator 1 auf, der über Anschlussleitungen 2 mit Eingängen 101 und 102 einer Schutzeinrichtung 100 verbunden ist. Die Schutzeinrichtung 100 weist zudem Ausgänge 103 und 104 auf, von denen Gleichstromleitungen 3 zu einem Wechselrichter 4 führen, der mit einem Stromversorgungsnetz 5 verbunden ist.

Beispielhaft ist der PV-Generator 1 in der Figur 1 durch das Schaltzeichen einer einzelnen Photovoltaikzelle symbolisiert. In einer Umsetzung der dargestellten PV-Anlage kann es sich bei dem PV-Generator 1 um ein einzelnes PV-Modul handeln, das seinerseits eine Vielzahl von Photovoltaikzellen enthält. Ebenso kann es sich bei dem PV-Generator 1 auch um eine Serienverschaltung mehrerer PV-Module handeln, einem sogenannten String, bei dem sich die Spannungen der einzelnen PV-Module addieren. Auch eine Parallelverschaltung oder eine gemischte Serien- und Parallelverschaltung von PV-Modulen ist möglich.

Die vom PV-Generator 1 bereitgestellte Spannung wird als Eingangsspannung Ui der Schutzeinrichtung 100 zugeführt. Beispielhaft sei der Eingang 101 mit negativem und der Eingang 102 mit demgegenüber positivem Potential beaufschlagt. Die von der Schutzeinrichtung 100 an den Ausgängen 103 und 104 abgegebene Spannung wird im Folgenden als Ausgangsspannung Uo bezeichnet.

Der Ausgang 103 ist im gezeigten Ausführungsbeispiel permanent niederohmig über eine Strommesseinrichtung 130 mit dem Eingang 101 verbunden, wohingegen der Ausgang 104 über ein Schaltorgan 110 mit dem Eingang 102 verbindbar ist. Die Strommesseinrichtung 130 ist Teil einer Steuereinheit 120 der Schutzeinrichtung 100, die von der an den Eingängen 101, 102 anliegenden Eingangsspannung Ui versorgt wird. Die Steuereinheit 120 steuert zum einen das Schaltorgan 110 abhängig von einem von der Strommesseinrichtung 130 in diesem Ausführungsbeispiel an dem Ausgang 103 gemessenen Stroms lo und stellt zum anderen eine Kleinspannung Us, auch Schutzspannung Us genannt, bereit, die an dem Ausgängen 103, 104 anliegt, wenn der Ausgang 104 nicht mit dem Eingang 102 verbunden ist. Zu diesem Zweck ist das Schaltorgan 110 in diesem Ausführungsbeispiel als Umschalter ausgeführt.

Wie unten detaillierter ausgeführt ist, verhindert die Schutzeinrichtung im Gefahrenfall das Auftreten von gefährlich hohen Spannungen an ihren Ausgängen 103, 104 und somit an den Gleichstromleitungen 3, die zum Wechselrichter 4 führen. Da der PV-Generator 1 bei Lichteinstrahlung unabhängig davon die Anschlussleitungen 2 mit einer Spannung von u. U. lebensgefährlicher Höhe beaufschlagt, wird die Schutzeinrichtung 100 bevorzugt möglichst nah am PV-Generator 1 positioniert, um die Länge der Anschlussleitungen 2 entsprechend kurz zu halten.

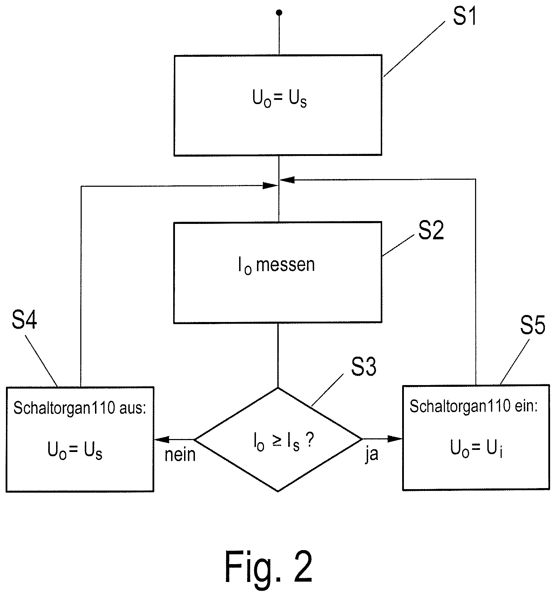

Im Folgenden wird anhand eines Flussdiagramms in Figur 2 ein Betriebsverfahren für eine Schutzeinrichtung erläutert, wobei beispielhaft und nicht einschränkend auf die in Figur 1 schematisch dargestellte Schutzeinrichtung verwiesen wird.

Es wird von einem Startpunkt des Verfahrens ausgegangen, zu dem der PV-Generator 1 keine oder nur eine vernachlässigbar kleine Ausgangsspannung liefert, z. B. nachts. Die Ausgangsspannung des PV-Generators 1 wird als Eingangsspannung Ui über die Eingänge 101 und 102 der Schutzeinrichtung 100 zugeführt. Steigt diese Eingangsspannung Ui nun aufgrund von wachsender Einstrahlungsintensität am PV-Generator 1 an, wird auch die Steuereinheit 120 der Schutzeinrichtung 100 ausreichend mit Betriebsspannung versorgt.

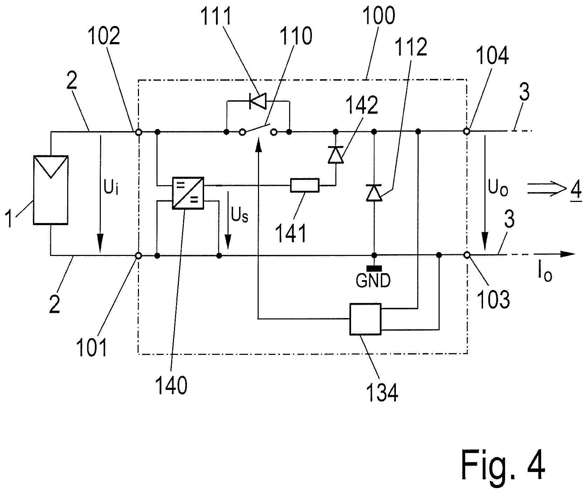

Die Steuereinrichtung 120 stellt daraufhin in einem ersten Schritt S1 an den Ausgängen 103 und 104 der Schutzeinrichtung 100 eine Kleinspannung Us bereit, deren Höhe unabhängig von der Eingangsspannung Ui einen für Gleichspannungen ungefährlichen Wert nicht übersteigt. Die Kleinspannung Us kann beispielsweise einige Volt bis einige 10 V betragen. Wichtig ist, dass die Kleinspannung Us im Bereich der sogenannten Schutzkleinspannungen liegt. Spannungen in diesem Bereich, der bei Gleichspannung bis etwa 120 V reicht, gelten bei Berührung als nicht lebensbedrohlich. Mit Bezug auf das Ausführungsbeispiel der Figur 4 wird vorab bemerkt, dass bei einer Serienschaltung mehrerer Schutzeinrichtungen 100 zu berücksichtigen ist, dass die Summe der Kleinspannungen Us der einzelnen Schutzeinrichtungen 100 im Bereich der Schutzkleinspannungen liegt. Die Kleinspannung Us liegt als Ausgangsspannung Uo an den Gleichstromleitungen 3 und dem Wechselrichter 4 an.

Es kann vorgesehen sein, dass die Höhe der Kleinspannung Us ab einer bestimmten Eingangsspannung Ui unabhängig von der Eingangsspannung und damit von der Lichtintensität ist, mit der der PV-Generator 1 bestrahlt wird. Alternativ ist es möglich, die Höhe der Kleinspannung Us abhängig von der Höhe der Eingangsspannung Ui zu machen, z. B. proportional zu dieser oder proportional innerhalb eines vorgegebenen Eingangsspannungsbereichs. Auf diese Weise wird dem Wechselrichter 4 über die Höhe der Kleinspannung Us Information über die Einstrahlungsintensität übermittelt, die dieser zur Steuerung seines eigenen Betriebszustands auswerten kann.

In einem nächsten Schritt S2 wird von der Steuereinheit 120 mittels der Strommesseinrichtung 130 die Größe des Stroms lo am Ausgang 103 bzw. 104 der Schutzeinrichtung 100 gemessen.

In einem weiteren Schritt S3 wird dieser Strom lo mit einem vorgegebenen unteren Schwellenwertstrom Isu verglichen. Wenn der Strom lo unterhalb des unteren Schwellenwertes Isu liegt, verzweigt das Verfahren zu einem Schritt S4, in dem das Schaltorgang 110 ausgeschaltet wird bzw. ausgeschaltet bleibt. Als Folge liegt an den Ausgängen 103, 104 als Ausgangsspannung Uo nach wie vor die Kleinspannung Us an. Das Verfahren springt daraufhin zurück zum Schritt S2, in dem wiederum der Strom lo gemessen wird. Falls der Strom lo dagegen im Schritt S3 größer oder gleich dem unteren Schwellenwert Isu ist, verzweigt das Verfahren zu einem nächsten Schritt S5.

In dem Schritt S5 wird der Strom lo mit einem vorgegebenen oberen Schwellenwertstrom Iso verglichen. Der Wechselrichter 4 ist - wie üblich bei Wechselrichtern - dazu ausgelegt, bei Detektion einer an seinem Gleichstromeingang anliegenden Spannung diesen Gleichstromeingang zu belasten, um dem PV-Generator elektrische Leistung zu entnehmen, die in Form von Wechselstrom in das Stromversorgungsnetz 5 eingespeist werden kann.

Die Belastung des Gleichstromeingangs des Wechselrichters 4 führt zu einem den Schwellenwertstrom Iso erreichenden oder übersteigenden Strom lo an den Ausgängen 103, 104 der Schutzeinrichtung 100. Von Schritt S5 verzweigt das Verfahren in diesem Fall zu einem Schritt S6, in dem die Steuereinheit 120 das Schaltorgan 110 einschaltet. Über das Schaltorgan 110 ist der Eingang 102 dann niederohmig mit dem Ausgang 104 verbunden. Da in diesem Ausführungsbeispiel der Eingang 101 dauerhaft niederohmig mit dem Ausgang 103 verbunden ist, stellt sich an den Ausgängen 103, 104 als Ausgangsspannung Uo im Wesentlichen die Eingangsspannung Ui, d. h. die vom PV-Generator 1 bereitgestellte Spannung, als Betriebsspannung ein. Aufgrund der niederohmigen Verbindung zwischen den Eingängen 101, 102 und den Ausgängen 103, 104 kann im Wesentlichen die gesamte vom PV-Generator 1 bereitgestellte elektrische Leistung über die Gleichstromleitungen 3 zum Wechselrichter 4 geführt werden, ebenso wie es bei einer direkten Verbindung des PV-Generators 1 mit dem Wechselrichter 4 ohne die Schutzeinrichtung 100 der Fall wäre. Der das Einschalten des Schaltorgans 110 hervorrufende Anstieg des Stroms Io kann seine Ursache auch in einem Anlaufen einer Stromversorgungseinheit oder eines Hochsetzstellers des Wechselrichters 4 haben. Auch ist es möglich, dass der Wechselrichter 4 aktiv eine Belastung seines Gleichstromeingangs vornimmt, die gewissermaßen als Steuersignal für die Schutzeinrichtung 100 dient. Nach dem Einschalten des Schaltorgans 110 im Schritt S6 springt das Verfahren zurück zum Schritt S2, in dem erneut der Strom lo gemessen wird.

Durch die Steuereinheit 120 der Schutzeinrichtung 100 wird der Strom lo permanent bzw. wiederholt gemessen (Schritt S2). Wenn, z. B. zu Wartungsarbeiten oder im Gefahrenfall der Wechselrichter 4 abgeschaltet wird oder vom Stromversorgungsnetz 5 getrennt wird, nimmt er gleichspannungsseitig keine elektrische Leistung mehr auf. Der Strom durch die Gleichstromleitungen 3 geht auf Null zurück und wird insbesondere kleiner als der untere Schwellenwert Isu. Dieses wird im Schritt S3 wiederum von der Schutzeinrichtung 100 detektiert, wobei im danach ausgeführten Schritt S4 das Schaltorgan 110 abgeschaltet wird. Als Ausgangsspannung Uo liegt dann wiederum nur die ungefährliche Kleinspannung Us an.

Der obere Schwellenwert Iso kann gleich dem unteren Schwellenwert Isu gewählt sein. Bevorzugt ist jedoch, dass der obere Schwellenwert Iso größer als der untere Schwellenwert Isu ist. Dadurch wird eine Schalthysterese eingeführt, die ein definiertes Umschalten zwischen den beiden Schaltzuständen des Schaltorgans 110 unterstützt. In einem Fall, in dem der Stom lo weder den unteren Schwellenwert unterschreitet, noch den oberen Schwellenwert erreicht oder überschreitet, erfolgt ein direkter Rücksprung zum Schritt S2, in dem erneut der Strom Io gemessen wird, ohne eine vorherige Verzweigung zu einem der Schritte S4 oder S6.

Bei diesem Ausführungsbeispiel stellt also die Höhe des gemessenen Stroms Io ein von der Schutzeinrichtung 100 empfangenes Signal dar, das mit vorgegebenen Kriterien verglichen wird, um den Schaltzustand des Schaltorgans 110 festzulegen. Die Kriterien beziehen sich auf die Höhe des Stroms Io und sind in Form der Schwellenwerte Isu und Iso angegeben. Das Beaufschlagen der Gleichstromleitungen 3 mit der Kleinspannung Us befähigt die Schutzeinrichtung 100 anhand der vorgenommenen Strommessung zur Detektion einer Leistungsanforderung durch den Wechselrichter 4, ohne dass zusätzliche Steuerleitungen oder aufmodulierte Steuersignale dazu notwendig wären. Die langen und häufig exponierten Gleichstromleitungen 3 tragen so nur in einem normalen Betriebszustand, in dem von keiner Gefährdung durch hohe Spannungen auf den Gleichstromleitungen 3 und großen fließenden Strömen auszugehen ist, die volle Gleichspannung des PV-Generators 1.

Im Gefahrenfall ist das übliche Vorgehen einer Feuerwehr, eine Brandstätte vor einem Löscheinsatz vom Stromversorgungsnetz zu trennen. Bei einer PV-Anlage wird erst durch die Schutzschaltung erreicht, dass ein an die übliche Vorgehensweise angelehntes Trennen der Wechselrichter vom Wechselspannungsnetz auch tatsächlich eine ausreichende Maßnahme darstellt, um zumindest die exponierten gleichstromseitigen Komponenten, wie die Gleichstromleitungen 3 und den Wechselrichter 4 selbst, von der gefährlich hohen vom PV-Generator erzeugten Gleichspannung zu trennen.

In einer alternativen Ausgestaltung der Schutzeinrichtung bzw. des Verfahrens ist vorgesehen, das Schaltorgan 110 erst einzuschalten, wenn ein vorbestimmtes Muster an Pulsen, während derer der Strom Io jeweils größer oder gleich dem oberen Schwellenwert Iso ist, detektiert wird. Dieses "kodierte" Einschalten kann unbeabsichtigtes Einschalten, z. B. durch Ströme, die als Folge von einer defekten Isolierung auch in einem Gefahrenfall fließen, verhindern. In einer weiteren Ausgestaltung, die im Zusammenhang mit Figur 4 weiter unten näher erläutert wird, ist vorgesehen, ein vergleichbares Pulsmuster anhand eines Spannungssignals oder anhand von Änderungen eines Spannungssignals an den Ausgängen der Schutzeinrichtung zu detektieren. Auch eine Detektion eines Stromsignals basierend auf Stromänderungen ohne Vorgabe von absoluten Stromschwellenwerten ist möglich.

Es ist bekannt, integriert in PV-Module, z. B. in eine Anschlussdose des PV-Moduls, Gleichspannungswandler vorzusehen, die beispielsweise im Betrieb als Hochsetzsteller arbeiten. Ein solcher Gleichspannungswandler kann im Sinne der Anmeldung als Schutzeinrichtung fungieren und ein Verfahren, wie es im Zusammenhang mit Figur 2 beschrieben ist, ausführen. Dazu ist der Gleichspannungswandler so eingerichtet, dass er an seinem Ausgang zunächst die Kleinspannung Us einstellt. Erst wenn von dem Gleichspannungswandler ein Signal detektiert wird, das ein vorbestimmtes Kriterium erfüllt, beispielsweise wenn ein über dem oberen Schwellenwert Iso liegender Strom Io festgestellt wird, wird der Gleichspannungswandler in einem normalen Betriebszustand zur Abgabe der im Wesentlichen gesamten Leistung des PV-Moduls (von Wandelverlusten sei abgesehen) betrieben. In diesem Betriebszustand wird am Ausgang des Gleichspannungswandlers eine Betriebsspannung eingestellt, die in ihrer Höhe nicht auf den Bereich der Schutzkleinspannungen beschränkt ist. Entsprechend wird von der Betriebsspannung wieder auf die Kleinspannung Us umgestellt, wenn das detektierte Signal das vorbestimmte Kriterium nicht mehr erfüllt, beispielsweise wenn der untere Stromschwellenwert Isu unterschritten wird.

Figur 3 zeigt den Aufbau einer Schutzeinrichtung 100 in einem weiteren Ausführungsbeispiel in einem detaillierten Schaltbild. Gleiche Bezugszeichen kennzeichnen in dieser wie in den folgenden Figuren gleiche und gleich wirkende Elemente wie in Figur 1.

Beispielhaft ist die Schutzeinrichtung 100 mit ihren Eingängen 101 und 102 über Anschlussleitungen 2 wiederum mit einem PV-Generator 1 verbunden, der als einzelne Photovoltaikzelle symbolisiert ist. Es gilt das zu Figur 1 gesagte in diesem wie auch in folgenden Ausführungsbeispielen, demzufolge es sich bei dem PV-Generator 1 um ein oder mehrere, insbesondere reihenverschaltete PV-Module handeln kann.

Neben den Eingängen 101 und 102 weist die Schutzeinrichtung 100 Ausgänge 103 und 104 auf. Während der Ausgang 103 dauerhaft über einen Strommesswiderstand (Shunt) 131 niederohmig mit dem Eingang 101 verbunden ist, ist der Ausgang 104 schaltbar über das Schaltorgan 110 mit dem Eingang 102 verbindbar. Das Schaltorgan 110 ist symbolisch als ansteuerbarer Schalter wiedergegeben, bevorzugt ist das Schaltorgan 110 als Halbleiterschalter ausgeführt, z. B. in Form eines IGBT (Insulated Gate Bipolar Transistor) oder eines MOSFET (Metal Oxid Semiconductor Field Effect Transistor). Das Schaltorgan 110 kann wie dargestellt den Ausgang 104 schalten. Es ist aber ebenso möglich, mittels des Schaltorgans 110 den Ausgang 103 oder auch, in einer mehrpoligen Ausführung des Schaltorgans 110, beide Ausgänge 103, 104 zu schalten. Auch kann, beispielsweise zur Erhöhung der Schaltsicherheit, vorgesehen sein, mehrere Schalter, beispielsweise Halbleiterschalter, in einer Reihenverschaltung als Schaltorgan 110 einzusetzen.

Parallel zur Schaltstrecke des Schaltorgans 110 ist eine Diode 111 angeordnet. Die Diode 111 schützt ein als Halbleiterschalter ausgeführtes Schaltorgan 110 vor zu hohen Sperrspannungen, die auftreten könnten, wenn der PV-Generator 1 verschattet ist, aber über die Ausgänge 103, 104 Spannung anliegt, z. B. aufgrund eines Kondensators im Gleichstromeingangskreis des Wechselrichters. Je nach verwendetem Halbleiterschalter ist die Diode 111 aufgrund des inneren Aufbaus des Halbleiters bereits im Halbleiterschalter integriert. Sie wird in einem solchen Fall auch als intrinsische Diode bezeichnet.

Eine weitere Diode 112 ist antiparallel zu den Ausgängen 103, 104 geschaltet. Sie dient als Bypassdiode für einen Anwendungsfall, in dem mehrere PV-Generatoren 1 mit jeweils eigenen Schutzschaltungen 100 in Serie verschaltet sind. Eine solche Anlagenkonzeption wird auch im Zusammenhang mit Figur 4 näher erläutert.

Zusammen mit einem Schwellenwertschalter 132 bildet der Strommesswiderstand 131 eine Strommesseinrichtung 130. Am Eingang des Schwellenwertschalters 132 stellt sich gegenüber einem für die Schutzeinrichtung 100 geltenden Bezugspotenzial GND eine zum Strom Io proportionale Spannung ein. Diese wird im Schwellenwertschalter 132 mit einer zu einem vorgegebenen Strom Is korrespondierenden Spannung verglichen. Der Ausgang des Schwellenwertschalters 132 wird mit einer Spannung beaufschlagt, wenn der Strom Io den vorgegebenen Schwellenwert Is überschreitet. Zur sicheren Erkennung und zum Erreichen von definierten Schaltzuständen kann dabei eine Hysterese im Schaltvorgang vorgesehen sein. Wie bereits im Zusammenhang mit Figur 2 beschrieben ist, sind dann ein unterer und eine oberer Schwellenwert Isu, Iso vorgegeben, die voneinander abweichen. Die Schwellenwerte sind so gewählt, dass ein Einschalten des Schaltorgans 110 bei Berührung einer der Gleichstromleitungen 3 oder bei einem stark verringerten Isolationswiderstand der Gleichstromleitungen 3 oder des Gleichstromeingangs des Wechselrichters 4, z. B. durch Löschwasser, ausgeschlossen ist.

Der Schwellenwertschalter 132 ist mit einem Zeitglied 133 verbunden, dessen Ausgang dann mit einer von Null verschiedenen Spannung beaufschlagt wird, wenn an seinem Eingang länger als ein vorgegebener Zeitraum tx das von Null verschiedene Signal anliegt. Von dem Ausgang des Zeitglieds 133 wird das Schaltorgan 110 geschaltet. Das Zeitglied 133 schließt aus, dass kurze Störspannungsimpulse, die beispielsweise in den Gleichstromleitungen 3 induziert werden, zum Schalten des Schaltorgans 110 führen. Erst wenn ein länger als der vorgegebene Zeitraum tx, z. B. länger als einige hundert Millisekunden oder einige Sekunden, andauernder Stromfluss lo größer Is detektiert wird, schaltet das Schaltorgan 110 ein, wobei ggf. eine weitere Zeitverzögerung vor dem Einschalten durchlaufen wird. Die weitere Zeitverzögerung stellt sicher, dass bei mehreren parallel geschalteten Schutzeinrichtungen 100 ein Einschalten einer ersten Schutzeinrichtung 100 nicht den Stromfluss an den Ausgängen 103, 104 der weiteren Schutzeinrichtungen 100 vor dem Ablauf des jeweiligen vorgegebenen Zeitraums tx unterbricht.

Aus Sicherheitsgründen ist im umgekehrten Fall, dem Absinken des Stromes Io unter den Schwellwert Is, vorteilhaft keine Zeitverzögerung vorgesehen. In diesem Fall schaltet das Schaltorgan 110 unmittelbar nach Unterschreiten der Schaltschwelle ab und schaltet erst wieder ein, wenn die Schaltschwelle länger als der vorgegebene Zeitraum tx überschritten wird.

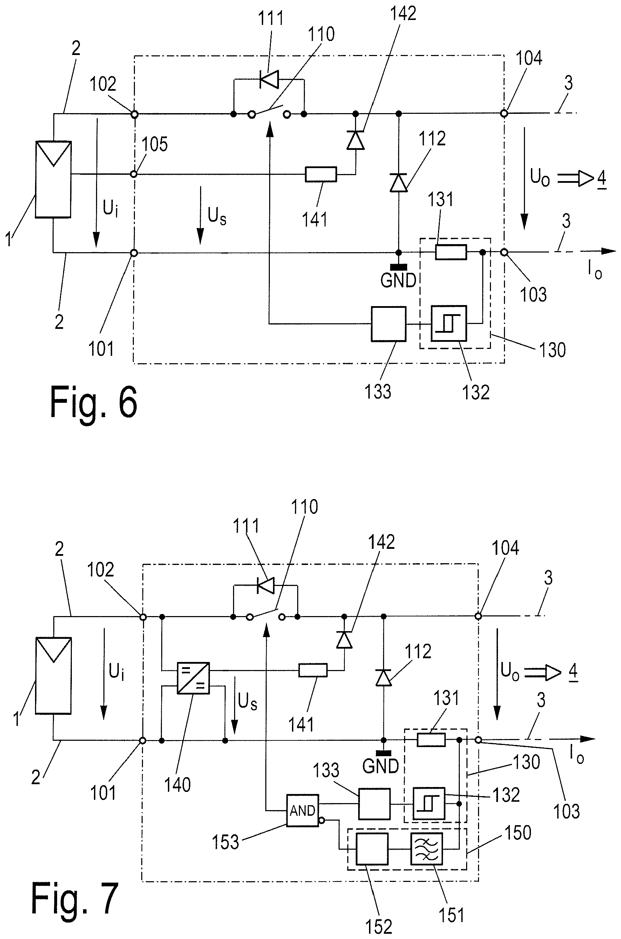

Im Ausführungsbeispiel der Figur 3 wird die Kleinspannung Us über einen Gleichspannungswandler (DC/DC-Wandler) 140 aus der Eingangsspannung Ui erzeugt. Die Kleinspannung Us wird mit ihrem negativen Pol mit dem Bezugspotential GND verbunden und mit ihrem positiven Pol über einen Vorwiderstand 141 und eine Diode 142 auf den Ausgang 104 geführt. Die Diode 142 verhindert einen Stromrückfluss in den DC/DC-Wandler 140, falls der Ausgang 104 mit einer über der Kleinspannung Us liegenden Spannung beaufschlagt wird, z. B. wenn das Schaltorgan 110 eingeschaltet ist. Der Vorwiderstand 141 dient der Begrenzung des aufgrund der Kleinspannung Us fließenden Stroms. Der Vorwiderstand 141 darf selbstverständlich nicht so groß gewählt werden, dass ein Stromfluss größer als der Schwellenwert Is bei gegebener Höhe der Kleinspannung Us nicht erreicht wird. Eine besondere Bedeutung erhält der Vorwiderstand 141 im Zusammenhang mit mehreren zusammengeschalteten, insbesondere parallel geschalteten Schutzeinrichtungen und im Zusammenhang mit einer Lichtbogenlöschung, wie im Zusammenhang mit Figur 6 beschrieben ist. Alternativ oder zusätzlich zum Vorwiderstand 141 kann der DC/DC-Wandler 140 auch aktiv geregelt strombegrenzt ausgeführt sein.

Alternativ zum DC/DC-Wandler 140 kann auch ein als Längs- oder Querregler ausgeführter Spannungsregler eingesetzt werden, um die Eingangsspannung Ui auf die Kleinspannung Us zu begrenzen. Solche Regler sind einfacher im Aufbau, jedoch mit höheren Umwandlungsverlusten behaftet.

In einer weiteren Ausgestaltung ist eine Diode 111 nicht vorgesehen. Das Schaltorgan 110 öffnet bei Strömen lo kleiner oder gleich dem unteren Schwellenwert Isu und damit auch bei negativen Strömen (Rückströmen). Ohne die Diode 111 fließt bei geöffnetem Schaltorgan kein Rückstrom durch den PV-Generator 1. Diese Funktionalität ist insbesondere bei einer Parallelschaltung von mehreren PV-Generatoren sinnvoll, da es hier andernfalls zu hohen Rückströmen in einem der PV-Generatoren kommen kann, z.B. durch eine Fehlverschaltung oder durch defekte Bypassdioden. Bei Einsatz einer Schutzschaltung, die einen Rückstrom unterbindet, kann auf die bislang bei einer Parallelverschaltung von PV-Generatoren, z.B. bei einer Parallelverschaltung von Strings, benutzte Sicherung verzichtet werden, wenn zu jedem der parallel zu verschaltenden PV-Generatoren eine derartige Schutzschaltung vorhanden ist. Falls Halbleiterschalter mit intrinsischen Dioden für das Schaltorgan 110 verwendet werden, können zwei solcher Halbleiterschalter bidirektional in Reihe verschaltet werden, um ein Schaltorgan 110 zu bilden, bei dem ein Rückstrom bei geöffnetem Schaltorgan 110 verhindert ist.

Figur 4 zeigt den Aufbau einer Schutzeinrichtung 100 in einem weiteren Ausführungsbeispiel in einem detaillierten Schaltbild. Wie bei dem in Figur 3 dargestellten Ausführungsbeispiel ist auch hier ein Schaltorgan 110 vorgesehen, über das einer der Eingänge, hier der Eingang 102, mit einem der Ausgänge, hier dem Ausgang 104, niederohmig verbindbar ist. Der andere Eingang 101 ist fest mit dem anderen Ausgang 103 verbunden. Weiter ist, ebenfalls wie bei dem Ausführungsbeispiel der Figur 3, ein DC/DC-Wandler 140 zur Erzeugung einer Schutzkleinspannung Us vorgesehen, mit der die Ausgänge 103, 104 über einen Vorwiderstand 141 und eine Diode 142 beaufschlagt werden, falls das Schaltorgan 110 geöffnet ist.

Im Unterschied zu den zuvor gezeigten Ausführungsbeispielen stellt vorliegend nicht die Höhe des von den Ausgängen abgegebenen Stroms lo das Signal dar, das mit vorgegebenen Kriterien verglichen wird. Stattdessen wird das Schaltorgan 110 eingeschaltet, wenn eine auf eine bestimmte Weise kodierte Signalform, beispielsweise eine Pulsfolge, detektiert wird, die auf die an den Ausgängen 103, 104 anliegende Gleichspannung aufmoduliert ist.

Die Schutzeinrichtung 100 weist zu diesem Zweck eine Dekodiereinheit 134 auf, der die an den Ausgängen 103, 104 anliegende Spannung Uo zur Auswertung zugeführt wird. Die Dekodiereinheit 134 überwacht, ob an den Ausgängen 103, 104 ein Spannungssignal vorliegt, das sich nach vorgegebenen Kriterien zeitlich ändert. Eine zeitliche Änderung, auch Modulation genannt, kann beispielsweise durch eine Folge von Pulsen (Pulsmuster) gegeben sein, wobei ein Puls jeweils durch einen kurzen Spannungseinbruch charakterisiert ist. Wenn ein vorgegebenes Muster detektiert wird, schaltet die Dekodiereinheit 134 das Schaltorgan 110 ein, wenn nicht wird (oder bleibt) das Schaltorgan 110 ausgeschaltet.

In einer hier nicht dargestellten Ausgestaltung kann die Dekodiereinheit 134 alternativ dazu eingerichtet sein, den an den Ausgängen 103, 104 fließenden Strom Io auf das Vorliegen eines modulierten Stromsignals auszuwerten. Ein Modulation des Stroms Io kann analog zum Fall der Auswertung der Ausgangsspannung Uo beispielsweise durch eine Folge von Pulsen gegeben sein, wobei ein Puls jeweils durch einen kurzen Stromanstieg charakterisiert ist.

Bei einer PV-Anlage mit der in diesem Ausführungsbeispiel beschriebenen Schutzeinrichtung 100 ist vorgesehen, dass ein entsprechendes Signal zum Einschalten des Schaltorgans 110 von einer entfernt von der Schutzeinrichtung 100 positionierten Einrichtung auf die Gleichstromleitungen 3 aufmoduliert wird. Im Normalfall wird das Signal mit dem vorgegebenes Muster wiederholt, z.B. periodisch auf die Gleichstromleitungen 3 aufmoduliert, wodurch diese mit der vom PV-Generator 1 bereitgestellten Spannung beaufschlagt werden. Im Gefahrenfall unterbleibt die Aufprägung des Signals mit dem vorgegebenen Muster, woraufhin die Schutzschaltung 100 die niederohmige Verbindung zwischen dem PV-Generator 1 und den Gleichstromleitungen 3 trennt und diese mit der ungefährlichen Kleinspannung Us beaufschlagt. Diese Ausführung ist besonders störungssicher, da beispielsweise ein Stromfluss aufgrund eines Kurzschlusses oder eines Lichtbogens nicht fälschlicherweise als Signal zum Einschalten des Schaltorgans gewertet wird. Bevorzugt kann ein komplexes Pulsmuster zum Einschalten ausgewählt sein, wobei eine Redundanzfunktion vorgesehen sein kann, so dass eine fehlerhafte Erkennung eines vermeintlichen Einschaltsignals minimiert oder praktisch ausgeschlossen ist.

Das Aufmodulieren kann dadurch erfolgen, dass mindestens ein taktbarer Schalter, der mit den Gleichstromleitungen 3 verbunden ist, über einen Signalgeber angesteuert wird. Beispielsweise kann der taktbare Schalter in einer Reihenschaltung mit einem Belastungswiderstand zwischen die beiden Gleichstromleitungen 3, also parallel zu den Eingangsanschlüssen eines Wechselrichters und damit parallel zu den Anschlüssen 103 und 104 der Schutzeinrichtung 100 geschaltet sein. Ein getaktetes Einschalten des Schalters führt zu einem der Schaltertaktung entsprechend modulierten Stromsignal, das wegen des von Null verschiedenen Innenwiderstands der Schutzeinrichtung 100 auch ein moduliertes Spannungssignal an den Anschlüssen 103 und 104 aufprägt. Der Innenwiderstand der Schutzeinrichtung 100 wird bei (noch) geöffnetem Schaltorgan 110 durch den Vorwiderstand 141 dominiert. Beim Anliegen der Kleinspannung Us ist damit ein relativ kleiner Strom durch den taktbaren Schalter ausreichend, um ein deutlich moduliertes Spannungssignal zu generieren. Der taktbare Schalter kann eigens zu diesem Zweck in den Wechselrichter 4 integriert sein. Ein solcher Schalter hätte den zusätzlichen Nutzen, dass ein in einer Eingangsstufe des Wechselrichters vorhandener Kondensator unabhängig vom Betriebszustand des Wechselrichters über die Reihenschaltung aus taktbarem Schalter und Belastungswiderstand entladen werden kann, was aus Sicherheitsgründen gewünscht sein kann.

Alternativ oder zusätzlich kann ein bereits vorhandener Schalter im Wechselrichter 4 zur Aufprägung des Strom- bzw. Spannungssignals eingesetzt werden, beispielsweise ein Schalter eines Gleichstromwandlers oder einer anderen Eingangsstufe des Wechselrichters 4. In einer bevorzugten Ausgestaltung kann beispielsweise ein separater taktbarer Schalter benutzt werden, wenn der Wechselrichter 4 noch nicht im Betrieb ist und die Gleichstromleitungen 3 mit der Kleinspannung Us beaufschlagt sind. Bei zunächst ausgeschaltetem Schaltorgan 110 wird ein den vorgegebenen Kriterien genügendes Signal zum Einschalten des Schaltorgans 110 zunächst von dem separaten taktbaren Schalter erzeugt. Nachdem das Spannungssignal von der Schutzschaltung 100 erkannt ist und entsprechend das Schaltorgan 110 geschlossen wurde, kann die Aufprägung des Signals durch die Schalter der Eingangsstufe erfolgen, die typischerweise eine größere Strombelastbarkeit haben.

Durch das getaktete Belasten der Gleichstromleitungen 3 wird ein Signal, beispielsweise in Form einer Pulsfolge, auf die Gleichstromleitungen 3 aufmoduliert, ohne dass ein materialintensiver Übertrager zur Einspeisung des modulierten Signals im Wechselrichter oder einer anderen generatorfernen Einrichtung benötigt würde. Letztlich wird dieses dadurch ermöglicht, dass die Schutzeinrichtung 100 die Kleinspannung Us bereitstellt.

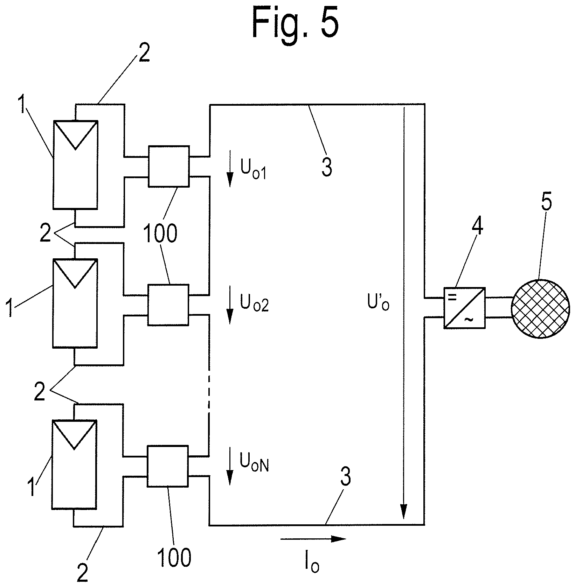

Figur 5 zeigt eine bevorzugte Ausgestaltung der Erfindung, bei der mehrere PV-Generatoren 1 vorgesehen sind, denen jeweils eine Schutzeinrichtung 100 zugeordnet ist, mit der der jeweilige PV-Generator 1 verbunden ist. In einer solchen Konstellation mit mehreren PV-Generatoren 1 werden diese auch als PV-Teilgeneratoren 1 bezeichnet. Die Schutzeinrichtungen 100 sind mit ihren Ausgängen seriell verschaltet und die Serienschaltung der Schutzeinrichtungen 100 ist mit dem Wechselrichter 4 verbunden.

Für eine Anzahl N von auf diese Weise zusammengeschalteten PV-Teilgeneratoren 1 mit zugeordneter Schutzeinrichtung 100 ergibt sich eine Gesamtausgangsspannung U'o, mit der die Gleichstromleitungen 3 und der Eingang des Wechselrichters 4 beaufschlagt sind, als Summe der an den Ausgängen der Schutzeinrichtungen 100 anliegenden Spannungen Uo. Der von den einzelnen Schutzeinrichtungen 100 detektierte fließende Strom Io ist für alle Schutzeinrichtungen gleich und entspricht dem in den Gleichstromleitungen 3 fließenden Strom Io. Wenn dieser Strom Io den Schwellenstrom Is überschreitet, wird dieses unabhängig voneinander von jeder der Schutzeinrichtungen 100 detektiert, die daraufhin nach Ablauf der vorgegebenen Zeitspanne tx die entsprechenden Schaltorgane 110 einschalten, woraufhin die von den jeweiligen PV-Generatoren 1 bereitgestellte elektrische Leistung zum Wechselrichter 4 übertragen werden kann.

Für die dargestellte serielle Verschaltung der Schutzeinrichtungen 100 ist es sinnvoll, eine jeweilige Kleinspannung Us im Bereich von einigen Volt einzusetzen. Auch bei Verschaltung von beispielsweise zehn PV-Teilgeneratoren 1 liegt die sich im Gefahrenfall ergebende Spannung auf den Gleichstromleitungen 3 dann im Bereich von einigen 10 V, was immer noch unterhalb der als gefährlich angesehenen Grenzspannung von 120 V für Gleichspannungsquellen liegt. Wenn zudem die maximale Ausgangsspannung eines jeden PV-Teilgenerators 1 kleiner als diese als gefährlich angesehene Grenzspannung von 120 V ist, liegt im Gefahrenfall an keiner Stelle der PV-Anlage eine gefährdende Spannung an, auch nicht innerhalb eines PV-Teilgenerators 1 oder auf den diesen mit der jeweiligen Schutzeinrichtung 100 verbindenden Leitungen.

Im Zusammenhang mit der in der Figur 5 gezeigten Anordnung ist es besonders vorteilhaft, ein einzelnes PV-Modul als PV-Teilgenerator 1 einzusetzen und die jeweilige Schutzeinrichtung 100 integriert in dieses PV-Modul, z. B. integriert in eine Anschlussdose des PV-Moduls, anzuordnen. Üblicherweise liegt bei einem PV-Modul die Maximalspannung unterhalb der Grenzspannung von 120 V. Auf diese Weise wird ein PV-Modul geschaffen, das wie ein bekanntes PV-Modul, das keine Schutzeinrichtung aufweist, innerhalb einer PV-Anlage z. B. reihenverschaltet zur Bildung eines Strings mit einem Wechselrichter 4 verbunden werden kann, wobei im Gefahrenfall an keiner Stelle der PV-Anlage eine gefährdende Spannung anliegt.

Die Anschlussdose kann zudem spritzwassergeschützt ausgeführt werden. Auf diese Weise kann verhindert werden, dass Anschlussleitungen, die innerhalb des PV-Moduls zu der Schutzeinrichtung 100 führen und an denen die ggf. hohe Ausgangsspannung des PV-Moduls unmittelbar anliegt, mit Löschwasser in Berührung kommen können. Somit wird auch mit PV-Modulen, deren maximale Ausgangsspannung über der genannten Grenzspannung von 120 V liegt, eine hohe Sicherheit im Gefahrenfall erreicht.

Alternativ zur oder kombiniert mit der Serienverschaltung ist auch eine Parallelverschaltung von PV-Generatoren 1 mit jeweils zugeordneten Schutzeinrichtungen 100 möglich. In einem solchen Fall ist zu bedenken, dass sich der durch den Wechselrichter und die Gleichstromleitungen 3 fließende Strom auf die einzelnen Schutzeinrichtungen 100 aufteilt, sodass zum Initiieren des Einschaltens der einzelnen Schaltorgane 110 ein insgesamt größerer Stromfluss vom Wechselrichter 4 angefordert werden muss. Da die Kleinspannungen Us der verschiedenen Schutzeinrichtungen 100 aufgrund von Bauteiltoleranzen der DC/DC-Wandler 140 nicht exakt gleich sein werden, könnte sich bei der Parallelverschaltung der Schutzeinrichtungen 100 eine stark ungleichmäßige Stromaufteilung auf die Schutzeinrichtungen 100 ergeben. Dieses wird durch den Vorwiderstand 141, über den der Ausgang der DC/DC-Wandler 140 auf den Ausgang 104 der Schutzeinrichtung 100 geführt ist, verhindert.

Figur 6 zeigt das Schaltbild eines weiteren Ausführungsbeispiels der Schutzeinrichtung 100 in einer Darstellung analog zu Figur 3. Im Unterschied zu dem Ausführungsbeispiel der Figur 3 ist hier ein weiterer Eingang 105 vorgesehen, der mit einem Spannungsabgriff am PV-Generator 1 verbunden ist. Der Spannungsabgriff am PV-Generator 1 greift eine Teilspannung der eigentlichen Ausgangsspannung ab.

Wenn der PV-Generator 1 beispielsweise eine Anordnung aus mehreren seriell verschalteten PV-Modulen ist, kann der Abgriff zwischen zwei der PV-Module ausgeführt sein. Bilden beispielsweise zehn in Serie verschaltete PV-Module den PV-Generator 1, kann der Abgriff zwischen dem ersten und dem zweiten PV-Modul vorgenommen sein, sodass die am Abgriff anliegende Spannung bei gleichmäßiger Einstrahlung über alle PV-Module des PV-Generators 1 ein zehntel der vom PV-Generator 1 insgesamt bereitgestellten Spannung beträgt.

Die abgegriffene Spannung wird am Eingang 105 als Kleinspannung Us der Schutzeinrichtung 100 zugeführt, von wo sie wieder über den Vorwiderstand 141 und die Diode 142 auf den Ausgang 104 der Schutzeinrichtung 100 gelegt wird. Durch die dargestellte Verschaltung kann die Schutzeinrichtung 100 ohne zusätzlichen Bauteilaufwand und ohne die mit einem DC/DC-Wandler oder einem Spannungsregler verbundenen Verluste, bzw. mit geringeren dieser Verluste, die Kleinspannung Us bereitstellen.

Die Bereitstellung der Kleinspannung Us über einen Spannungsabgriff kann in einer alternativen Ausgestaltung auch vorgenommen werden, wenn wie in Figur 5 gezeigt mehrere PV-Teilgeneratoren 1 mit jeweils einer eigenen zugordneten Schutzeinrichtung 100 seriell verschaltet werden. Dieses bietet sich insbesondere an, wenn als PV-Teilgeneratoren 1 einzelne PV-Module eingesetzt werden und die Schutzeinrichtung 100 in einer Anschlussdose des PV-Moduls angeordnet ist. Die PV-Zellen von PV-Modulen sind häufig zu mehreren Gruppen, z.B. drei Gruppen, zusammengefasst, wobei die PV-Zellen einer Gruppe innerhalb der Zellenanordnung reihenverschaltet sind. Die Anschlüsse der einzelnen Gruppen sind separat in die Anschlussdose geführt, wo sie dann seriell miteinander verbunden sind, wobei üblicherweise antiparallel zu jeder Gruppe eine Bypass-Diode vorgesehen ist. Somit sind Abgriffe des PV-Moduls, die Teilspannungen führen, bereits in der Anschlussdose verfügbar. Einer dieser Abgriffe kann an den weiteren Eingang 105 geführt werden, um auf einfache Weise die Kleinspannung Us aus dieser Teilspannung abzuleiten.

Figur 7 zeigt eine weitere Ausgestaltung der Schutzeinrichtung 100 in einem Schaltbild analog zu Figur 3. Im Unterschied zu den vorherigen Ausführungsbeispielen dient die hier dargestellte Schutzeinrichtung nicht nur der Abschaltung einer gefährlich hohen Gleichspannung auf den Gleichstromleitungen, sondern auch der Löschung eines Lichtbogens im Stromfluss zwischen dem PV-Generator 1 und dem Wechselrichter 4. Zu diesem Zweck ist eine Einrichtung zur Lichtbogenerkennung 150 vorgesehen, die beispielsweise einen Bandpassfilter 151 und einen nachgeschalteten Hüllkurvendetektor (Envelope Decoder) 152 aufweist. Andere Methoden zur Lichtbogenerkennung können ebenfalls eingesetzt werden.

Beim Abbrennen eines Lichtbogens zwischen zwei benachbarten Kontaktstellen bildet sich ein stark ionisiertes brennendes Plasma aus, über das der Stromfluss stattfindet. Der Stromfluss über einen Lichtbogen ist üblicherweise nicht konstant, sondern fluktuiert mit starken hochfrequenten Anteilen. Wenn sich an irgendeiner Stelle im Stromfluss zwischen dem PV-Generator 1 und dem Wechselrichter 4 ein Lichtbogen ausbildet, sind die Gleichspannungsleitungen 3 mit einem stark ausgeprägten hochfrequenten Störspektrum beaufschlagt. Das Vorliegen der hochfrequenten Störungen in einem für Lichtbögen charakteristischen Frequenzbereich wird durch den Bandpassfilter 151 und den nachfolgenden Hüllkurvendetektor 152 detektiert. Am Ausgang des Hüllkurvendetektors 152 liegt ein von Null verschiedenes Spannungssignal an, wenn ein Lichtbogen detektiert wird.

Der Ausgang des Hüllkurvendetektors 152 und der Ausgang des Zeitglieds 133 werden über ein logisches Und-Schaltelement 153 miteinander kombiniert, wobei der mit dem Hüllkurvendetektor 152 verbundene Eingang negiert ausgeführt ist. Der Ausgang des Und-Schaltelements 153 steuert das Schaltorgan 110. Als Folge dieser logischen Verknüpfung wird das Schaltorgan 110 eingeschaltet, wenn zum einen ein über einem oberen Schwellenwert Iso liegender Stromfluss lo für länger als der vorgegebene Zeitraum tx vorliegt und zum anderen kein Lichtbogen detektiert wird. Umgekehrt trennt das Schaltorgan 110 den Ausgang 104 von dem Eingang 102 ab, wenn ein Stromfluss lo kleiner als ein unterer Schwellenwert Isu beobachtet wird oder wenn ein Lichtbogen im Gleichstromkreis detektiert wird. Nach Trennung des Ausgangs 104 von dem Eingang 102 liegt an den Ausgängen 103, 104 wiederum nur die Kleinspannung Us an. Aufgrund des Vorwiderstandes 141 liefert die Schutzschaltung 100 in diesem Fall keinen zur Aufrechterhaltung des Lichtbogens ausreichenden Strom, sodass der Lichtbogen gelöscht wird. In Ausführungsbeispielen, in denen kein Vorwiderstand 141 vorhanden ist, wird gleiches durch eine dann vorgesehene Strombegrenzung des DC/DC-Wandlers 140 erreicht.

Lediglich beispielhaft beruhen die in den Figuren 5 bis 7 dargestellten Ausführungsbeispiele auf der in Zusammenhang mit der Figur 3 gezeigten Ausgestaltung, bei der die Höhe des Stromflusses am Ausgang der Schutzschaltung als Kriterium herangezogen wird, ob der Ausgang mit der Kleinspannung oder mit der Betriebsspannung des PV-Generators beaufschlagt wird. Es kann auch in diesen Ausführungen das dem Beispiel der Figur 4 zugrundeliegende Kriterium eines auf die Gleichspannungsleitungen aufgeprägten kodierten Signals eingesetzt werden.

### Bezugszeichenliste

- 1: PV-Generator
- 2: Anschlussleitungen
- 3: Gleichstromleitungen
- 4: Wechselrichter
- 5: Stromversorgungsnetz
- 100: Schutzeinrichtung
- 101, 102: Eingang
- 103, 104: Ausgang
- 105: weiterer Eingang
- 110: Schaltorgan
- 111: Diode
- 112: weitere Diode
- 120: Steuereinheit
- 130: Strommesseinrichtung
- 131: Strommesswiderstand
- 132: Schwellenwertschalter
- 133: Zeitglied
- 134: Dekodiereinheit
- 140: Gleichspannungswandler
- 141: Vorwiderstand
- 142: Diode
- 150: Einrichtung zur Lichtbogenerkennung
- 151: Bandpassfilter
- 152: Hüllkurvendetektor
- 153: UND-Schaltelement

## Patentansprüche

1. Schutzeinrichtung (100) für eine Photovoltaikanlage, aufweisend
- mindestens einen Eingang (101, 102) zur Verbindung mit einem Photovoltaikgenerator (1) und
- mindestens einen Ausgang (103, 104) zur Abgabe einer von dem Photovoltaikgenerator (1) gelieferten elektrischen Leistung,
**dadurch gekennzeichnet, dass**
die Schutzeinrichtung (100) eine Detektionseinrichtung für ein über den mindestens einen Ausgang (103, 104) zugeführtes Signal umfasst und dazu eingerichtet ist,
- an dem mindestens einen Ausgang (103, 104) eine in ihrer Höhe begrenzte Kleinspannung (Us) bereitzustellen, falls ein zugeführtes Signal vorgegebenen Kriterien nicht genügt und
- den mindestens einen Ausgang (103, 104) über ein Schaltorgan (110) niederohmig mit dem mindestens einen Eingang (101, 102) zu verbinden, falls das zugeführte Signal den vorgegebenen Kriterien genügt.

2. Schutzeinrichtung (100) nach Anspruch 1, bei der die Detektionseinrichtung eine Strommesseinrichtung (130) für einen an dem mindestens einen Ausgang (103, 104) abgegebenen Strom (lo) aufweist, wobei das zugeführte Signal mit einer Höhe des Stroms (lo) verknüpft ist.

3. Schutzeinrichtung (100) nach Anspruch 1, bei der die Detektionseinrichtung eine Spannungsmesseinrichtung für eine an dem mindestens einen Ausgang (103, 104) anliegende Spannung (Uo) aufweist, wobei das zugeführte Signal mit einer Höhe der Spannung (Uo) verknüpft ist.

4. Schutzeinrichtung (100) nach einem der Ansprüche 1 bis 3, bei der die vorgegebenen Kriterien eine zeitliche Modulation des Signals, insbesondere ein Pulsmuster, betreffen.

5. Schutzeinrichtung (100) nach Anspruch 2, bei der die vorgegebenen Kriterien die Höhe des Stroms (lo) betreffen, wobei die Schutzeinrichtung (100) dazu eingerichtet ist, die Kleinspannung (Us) an dem mindestens einen Ausgang (103, 104) bereitzustellen, falls der abgegebene Strom (lo) kleiner als ein unterer Schwellenwert (Isu) ist und den mindestens einen Ausgang (103, 104) über das Schaltorgan (110) niederohmig mit dem mindestens einen Eingang (101, 102) zu verbinden, wenn der abgegebene Strom (lo) größer oder gleich einem oberen Schwellenwert (Iso) ist, wobei der obere Schwellenwert (Iso) größer oder gleich dem unteren Schwellenwert (Isu) ist.

6. Schutzeinrichtung (100) nach einem der Ansprüche 1 bis 5, aufweisend einen weiteren Eingang (105), um eine Teilspannung des Photovoltaikgenerators (1) zur unmittelbaren Bereitstellung oder zur Erzeugung der Kleinspannung (Us) zuzuführen, und/oder aufweisend einen DC/DC-Wandler (140), einen Längsregler oder einen Querregler zur Begrenzung der Kleinspannung (Us).

7. Schutzeinrichtung (100) nach einem der Ansprüche 1 bis 6, bei der die Kleinspannung (Us) über einen Vorwiderstand (141) hochohmig und/oder über eine Diode (142) auf den mindestens einen Ausgang (103, 104) geschaltet ist.

8. Schutzeinrichtung (100) nach einem der Ansprüche 1 bis 7, bei der ein Zeitglied (133) vorgesehen ist, durch das die Ansteuerung des Schaltorgans (110) derart verzögert wird, dass ein Einschalten des Schaltorgans (110) erst erfolgt, wenn das Signal länger als ein vorgegebener Zeitraum (tx) den vorgegebenen Kriterien genügt.

9. Schutzeinrichtung (100) nach einem der Ansprüche 1 bis 8, aufweisend eine Einrichtung zur Lichtbogenerkennung (150), die mit dem Schaltorgan (110) zu dessen Steuerung derart verbunden ist, dass das Schaltorgan (110) trennt, wenn ein Lichtbogen erkannt wird.

10. Photovoltaikmodul, **gekennzeichnet durch** eine integrierte und insbesondere in einer Anschlussdose des Photovoltaikmoduls angeordnete Schutzeinrichtung (100) nach einem der Ansprüche 1 bis 9.

11. Photovoltaikmodul nach Anspruch 10, bei dem die Schutzeinrichtung (100) einen weiteren Eingang (105) aufweist, der mit einem Teilabgriff des Photovoltaikmoduls verbunden ist, um eine Teilspannung des Photovoltaikgenerators (1) zur unmittelbaren Bereitstellung oder zur Erzeugung der Kleinspannung (Us) zuzuführen.

12. Betriebsverfahren für eine Schutzeinrichtung (100) einer Photovoltaikanlage, die mindestens einen Eingang (101, 102) zur Verbindung mit einem Photovoltaikgenerator (1) und mindestens einen Ausgang (103, 104) zur Abgabe einer von dem Photovoltaikgenerator (1) bereitgestellten elektrischen Leistung aufweist, mit den Schritten:
- Beaufschlagen des mindestens einen Ausgangs (103, 104) mit einer Kleinspannung (Us);
- Überwachen des mindestens einen Ausgangs (103, 104) auf ein Vorliegen eines Signals und ggf. Detektieren eines vorliegenden Signals;
- Beaufschlagen des mindestens einen Ausgangs (103, 104) mit einer Betriebsspannung zur Abgabe der gesamten von dem Photovoltaikgenerator (1) bereitgestellten elektrischen Leistung, wenn ein detektiertes Signal vorgegebenen Kriterien genügt; und
- Beaufschlagen des mindestens einen Ausgangs (103, 104) mit der Kleinspannung (Us), wenn kein Signal vorliegt oder das detektierte Signal vorgegebenen Kriterien nicht genügt.

13. Betriebsverfahren nach Anspruch 12, bei dem die vorgegebenen Kriterien einen über eine zeitliche Modulation des Signals übertragenen Betriebszustands eines Wechselrichters (4) der Photovoltaikanlage betreffen.

14. Betriebsverfahren nach Anspruch 12, bei dem die vorgegebenen Kriterien eine Höhe eines an dem mindestens einen Ausgang (103, 104) abgegebenen Stroms (lo) betreffen, wobei der mindestens eine Ausgang (103, 104) mit der Betriebsspannung beaufschlagt wird, wenn der abgegebene Strom (lo) größer oder gleich einem oberen Schwellenwert (Iso) ist und mit der Kleinspannung (Us), wenn der abgegebene Strom (lo) kleiner als ein unterer Schwellenwert (Isu) ist, wobei der untere Schwellenwert (Isu) kleiner oder gleich dem oberen Schwellenwert (Iso) ist.

15. Betriebsverfahren nach einem der Ansprüche 12 bis 14, mit den weiteren Schritten:
- Überwachen, ob an dem mindestens einen Ausgang (103, 104) ein Signal anliegt, das für das Vorhandensein eines Lichtbogens charakteristisch ist; und
- Beaufschlagen des mindestens einen Ausgangs (103, 104) mit der Kleinspannung (Us) beim Vorhandensein eines solchen Signals.

## Claims

1. Protective device (100) for a photovoltaic system, comprising
- at least one input (101, 102) for connection to a photovoltaic generator (1) and
- at least one output (103, 104) for delivery of electric power supplied by the photovoltaic generator (1),
**characterized in that**
the protective device (100) comprises a detection device for a signal applied via the at least one output (103, 104), and is adapted for
- providing a low voltage (Us) limited in its level at the at least one output (103, 104) in case that a supplied signal does not meet predetermined criteria, and
- connecting the at least one output (103, 104) with low resistance to the at least one input (101, 102) via a switching device (110) in case that the applied signal meets the predetermined criteria.

2. Protective device (100) according to claim 1, wherein the detection device comprises a current measuring device (130) for the current (Io) emitted at the at least one output (103, 104), wherein the applied signal is associated with a magnitude of the current (lo).

3. Protective device (100) according to claim 1, wherein the detection device comprises a voltage measuring device for the voltage (Uo) applied at the at least one output (103, 104), wherein the applied signal is associated with a level of the voltage (Uo).

4. Protective device (100) according to any one of claims 1 to 3, wherein the predetermined criteria are related to a temporal modulation of the signal, in particular to a pulse pattern.

5. Protective device (100) according to claim 2, wherein the predetermined criteria are related to the magnitude of the current (lo), wherein the protective device (100) is adapted to provide the low voltage (Us) at the at least one output (103, 104), if the emitted current (Io) is less than a lower threshold (Isu) and to connect the at least one output (103, 104) with low resistance to the at least one input (101, 102) via the switching device (110), if the emitted current (Io) is greater than or equal to an upper threshold (Iso), wherein the upper threshold (Iso) is greater than or equal to the lower threshold (Isu).

6. Protective device (100) according to any one of claims 1 to 5, comprising a further input (105) to apply a partial voltage from the photovoltaic generator (1) for the direct supply or for the generation of the low voltage (Us) and/or comprising a DC-DC converter (140), a series regulator or a shunt regulator for limiting the low voltage (Us).

7. Protective device (100) according to any one of claims 1 to 6, wherein the low voltage (Us) is connected to the at least one output (103, 104) at high impedance via a series resistor (141) and/or via a diode (142).

8. Protective device (100) according to any one of claims 1 to 7, wherein a timer (133) is provided, by which the control of the switching device (110) is delayed such that a switching on of the switching device (110) takes place only if the signal meets the predetermined criteria for more than a predetermined period of time (tx).

9. Protective device (100) according to any one of claims 1 to 8, comprising means for electric arc detection (150) that are connected to the switching device (110) for the control thereof in such a way that the switching device (110) opens if an electric arc is detected.

10. Photovoltaic module, **characterized by** an integrated protective device (100) according to one of claims 1 to 9 that is particularly arranged in a junction box of the photovoltaic module.

11. Photovoltaic module according to claim 10, wherein the protective device (100) comprises a further input (105) that is connected to a tap of the photovoltaic module in order to apply a partial voltage of the photovoltaic generator (1) for the direct supply or for the generation of the low voltage (Us).

12. Operating method for a protective device (100) of a photovoltaic system that comprises at least one input (101, 102) for connection to a photovoltaic generator (1) and at least one output (103, 104) for delivery of the electric power supplied by the photovoltaic generator (1), comprising the steps of:
- Applying a low voltage (Us) to the at least one output (103, 104);
- Monitoring the at least one output (103, 104) for a presence of a signal and, if applicable, detecting a present signal;
- Applying an operating voltage to the at least one output (103, 104) for delivery of the total electric power supplied by the photovoltaic generator (1), if a detected signal meets predetermined criteria, and
- Applying the low voltage (Us) to the at least one output (103, 104), if there is no signal present or if the detected signal does not meet specified criteria.

13. Operating method according to claim 12, wherein the predetermined criteria are related to an operating state of an inverter (4) of the photovoltaic system that is transmitted by means of a temporal modulation of the signal.

14. Operating method according to claim 12, wherein the predetermined criteria are related to a magnitude of a current (Io) emitted at the at least one output (103, 104), wherein the at least one output (103, 104) is supplied with the operating voltage, if the emitted current (Io) is greater than or equal to an upper threshold (Iso) and with the low voltage (Us), if the output current (Io) is less than a lower threshold (Isu), wherein the lower threshold (Isu) is less than or equal to the upper threshold (Iso).

15. Operating method according to any one of claims 12 to 14, further comprising the steps of:
- Monitoring whether a signal is present at the at least one output (103, 104), that is characteristic for the presence of an electric arc, and
- Applying the low voltage (Us) to the at least one output (103, 104) in the presence of such a signal.

## Revendications

1. Dispositif de protection (100) pour une installation photovoltaïque, comprenant
- au moins une entrée (101, 102) pour le raccordement à un générateur photovoltaïque (1), et
- au moins une sortie (103, 104) pour fournir une puissance électrique fournie par le générateur photovoltaïque (1),
**caractérisé en ce que**
le dispositif de protection (100) comprend un dispositif de détection d'un signal alimenté via la au moins une sortie (103, 104) et est agencé,
- pour fournir à la au moins une sortie (103, 104) une basse tension (Us) limitée dans sa hauteur si un signal alimenté ne satisfait pas à des critères prédéterminés, et
- pour connecter la au moins une sortie (103, 104) à la au moins une entrée (101, 102) à faible impédance via un élément de commutation (110) si le signal alimenté satisfait aux critères prédéterminés.

2. Dispositif de protection (100) selon la revendication 1, dans lequel le dispositif de détection comporte un dispositif de mesure de courant (130) pour un courant (Io) délivré sur la au moins une sortie (103, 104), le signal alimenté étant relié à un niveau du courant (Io).

3. Dispositif de protection (100) selon la revendication 1, dans lequel le dispositif de détection comporte un dispositif de mesure de tension (Uo) appliqué à la au moins une sortie (103, 104), le signal alimenté étant relié à un niveau de la tension (Uo).

4. Dispositif de protection (100) selon l'une des revendications 1 à 3, dans lequel les critères prédéterminés concernent une modulation temporelle du signal, en particulier un motif d'impulsions.

5. Dispositif de protection (100) selon la revendication 2, dans lequel les critères prédéterminés concernent le niveau de courant (Io), le dispositif de protection (100) étant adapté pour fournir la basse tension (Us) à la au moins une sortie (103, 104) si le courant délivré (Io) est inférieur à un seuil inférieur (Isu) et pour connecter la au moins une sortie (103, 104) à la au moins une entrée (101, 102) par l'intermédiaire de l'organe de commutation (110) à faible impédance lorsque le courant (Io) délivré est supérieur ou égal à une valeur seuil supérieure (Iso), la valeur seuil supérieure (Iso) étant supérieure ou égale à la valeur seuil inférieure (Isu).

6. Dispositif de protection (100) selon l'une des revendications 1 à 5, comportant une autre entrée (105) pour alimenter une tension partielle du générateur photovoltaïque (1) pour fournir directement ou générer la basse tension (Us), et/ou comportant un convertisseur CC-CC (140), un régulateur longitudinal ou un régulateur transversal pour limiter la basse tension (Us).

7. Dispositif de protection (100) selon l'une des revendications 1 à 6, dans lequel la basse tension (Us) est reliée à la au moins une sortie (103, 104) par une résistance série (141) à haute impédance et/ou par une diode (142).

8. Dispositif de protection (100) selon l'une des revendications 1 à 7, dans lequel il est prévu une minuterie (133) au moyen de laquelle l'activation de l'élément de commutation (110) est retardée de telle sorte que l'élément de commutation (110) ne soit activé que si le signal satisfait aux critères prédéterminés pendant une durée supérieure à une durée prédéterminée (tx).

9. Dispositif de protection (100) selon l'une des revendications 1 à 8, comportant un dispositif de détection d'arc (150) qui est relié à l'élément de commutation (110) pour commander celui-ci de telle sorte que l'élément de commutation (110) déconnecte lorsqu'un arc est détecté.

10. Module photovoltaïque, **caractérisé par** un dispositif de protection intégré (100), disposé en particulier dans une boîte de jonction du module photovoltaïque, selon l'une des revendications 1 à 9.

11. Module photovoltaïque selon la revendication 10, dans lequel le dispositif de protection (100) comporte une autre entrée (105) reliée à une prise partielle du module photovoltaïque pour alimenter une tension partielle du générateur photovoltaïque (1) pour la fourniture directe ou la génération de la basse tension (Us).

12. Procédé de fonctionnement d'un dispositif de protection (100) d'une installation photovoltaïque qui comporte au moins une entrée (101, 102) pour le raccordement à un générateur photovoltaïque (1) et au moins une sortie (103, 104) pour fournir une puissance électrique fournie par le générateur photovoltaïque (1), comportant les étapes :
- appliquer une basse tension (Us) à la au moins une sortie (103, 104) ;
- surveiller la au moins une sortie (103, 104) pour la présence d'un signal et éventuellement détecter un signal présent ;
- appliquer une tension de fonctionnement à la au moins une sortie (103, 104) pour fournir toute la puissance électrique fournie par le générateur photovoltaïque (1) si un signal détecté satisfait à des critères prédéterminés; et
- appliquer une basse tension (Us) à la au moins une sortie (103, 104) si aucun signal n'est présent ou si le signal détecté ne satisfait pas aux critères prédéterminés.

13. Procédé de fonctionnement selon la revendication 12, dans lequel les critères prédéterminés concernent un état de fonctionnement d'un onduleur (4) de l'installation photovoltaïque transmis via une modulation temporelle du signal.

14. Procédé de fonctionnement selon la revendication 12, dans lequel les critères prédéterminés concernent un niveau d'un courant (Io) délivré à la au moins une sortie (103, 104), la au moins une sortie (103, 104) étant alimentée avec la tension de fonctionnement lorsque le courant délivré (Io) est supérieur ou égal à une valeur seuil supérieure (Iso) et avec la basse tension (Us) lorsque le courant délivré (Io) est inférieur à une valeur seuil inférieure (Isu), la valeur seuil inférieur (Isu) étant inférieure ou égale à la valeur seuil supérieure (Iso).

15. Procédure de fonctionnement selon l'une des revendications 12 à 14, avec les étapes suivantes:
- surveiller si un signal caractéristique de la présence d'un arc est présent sur la au moins une sortie (103, 104) ; et
- appliquer la basse tension (Us) à la au moins une sortie (103, 104) en présence d'un tel signal.
